# EUROPÄISCHE PATENTSCHRIFT

(11) **EP 0 734 642 B1**
(45) Veröffentlichungstag und Bekanntmachung des Hinweises auf die Patenterteilung: **08.03.2000**
(21) Anmeldenummer: 95928970.3
(22) Anmeldetag: 24.08.1995
(51) Int. Cl.: H05K 3/34, H05K 13/04

(54) **VERFAHREN UND EINRICHTUNG ZUM AUTOMATISCHEN BESTÜCKEN DER OBER- UND UNTERSEITE VON LEITERPLATTEN MIT SMD-BAUTEILEN**
PROCESS AND DEVICE FOR AUTOMATICALLY FITTING THE TOP AND BOTTOM SIDES OF PRINTED CIRCUIT BOARDS WITH SMD COMPONENTS
PROCEDE ET DISPOSITIF D'IMPLANTATION AUTOMATIQUE DE COMPOSANTS MONTES EN SURFACE, DANS LA FACE SUPERIEURE ET LA FACE INFERIEURE DE CARTES DE CIRCUITS

(30) Priorität: 20.09.1994 DE 4433378
(43) Veröffentlichungstag der Anmeldung: 02.10.1996
(60) Teilanmeldung: 99112212.8
(73) Patentinhaber: Blaupunkt-Werke GmbH, 31132 Hildesheim (DE)
(72) Erfinder: SABOTKE, Jens, D-31139 Hildesheim (DE); GRAEN, Ansgar, D-31199 Diekholzen (DE); HEINRICH, Hans-Walter, D-31139 Hildesheim (DE)
(86) Internationale Anmeldenummer: DE9501121
(87) Internationale Veröffentlichungsnummer: WO9609749

(56) Entgegenhaltungen:
- DE-A- 3 113 031
- TOUTE L'ELECTRONIQUE, Nr.516, August/September 1986, PARIS FR Seiten 54 - 63 'Technologie du montage en surface des composants: les procédés de montage et de brasure'
- PATENT ABSTRACTS OF JAPAN vol. 17, no. 528 (E-1437) 22. September 1993 & JP,A,05 145 214 (TEAC CORP.) 11. Juni 1993

## Beschreibung

Gegenstand des Schutzrechtes ist eine Einrichtung zum automatischen Bestücken der Ober- und Unterseite von Leiterplatten mit SMD-Bauteilen.

Ein überblick über die SMD-Technologie wird in dem Artikel 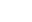 Technologie du montage en surface des composants", erschienen in Toute l'Electronique Nr. 516, Aug./Sept. 1986, 5.54-63, gegeben.

Die zu bestückenden Leiterplatten weisen in der Regel auf ihrer Unterseite ein Netz von Leiterbahnen auf, die die darin vorgesehenen Anschlußpunkte der Bauelemente funktionsgerecht miteinander verbinden. Diese Leiterplatten durchlaufen mittels eines Transportbandes die einzelnen Bearbeitungsstationen und passieren dabei auch Einrichtungen zum Bestücken der Leiterplatte von oben, sogenannte Bestückungsautomaten oder SMD-Bestücker, die die Bauteile in vorgegebene Positionen auf der Oberseite der Leiterplatte bringen. Dazu verfügen die Bestückungsautomaten über Greiforgane, die sich in einer horizontalen Ebene zu jedem Punkt der Leiterplattenoberfläche steuern lassen. Die Bauteile selbst sind auf einen Träger bevorratet, der in vielen Fällen zu einer Rolle aufgerollt ist. Von diesem Träger werden die Bauteile nacheinander, z. B. von einem Bestücksauger, abgenommen und zu dar vorgesehenen Position verbracht.

Nach dem Absetzen aller für die auf der Leiterplatte dargestellten Schaltungen erforderlichen SMD-Bauteile werden die Bauteile mit ihren Anschlußpunkten in einer Lötstation verlötet, und danach wird die Schaltung auf ihre einwandfreie Funktion hin geprüft.

Der Wunsch, den Raumbedarf dieser Schaltungen möglichst gering zu halten, hat dazu geführt, SMD-Bauelemente auch auf der Unterseite der Leiterplatten anzuordnen. Dazu wird nach der Lötstation die Leiterplatte vom Transportband abgehoben und gewendet und die nunmehr obenliegende Unterseite der Leiterplatte an den dortigen Plazierungen für SMD-Bauteile mit einem Kleber versehen. Anschließend durchläuft die Leiterplatte einen zweiten Bestückungsautomaten oder SMD-Bestücker und dort wird die nunmehr nach oben weisende Unterseite der Leiterplatte mit weiteren SMD-Bauteilen bestückt.

Hinter dem zweiten Bestückungsautomaten wird der Kleber in einer Härtestation ausgehärtet, so daß die Bauelemente fest auf der Leiterplatte haften; anschließend wird die Leiterplatte wieder gewendet, und danach durchläuft die Leiterplatte eine Wellenlötstation, um die Bauteile auf der Unterseite mit den Leiterbahnen zu verlöten.

Gegebenenfalls werden vorher noch Bauelemente von Hand auf die Oberseite der Leiterplatte aufgesetzt, die nicht mit einem Bestücksauger manipulierbar sind.

Der Erfindung lag die Aufgabe zugrunde, falls möglich, diesen Aufwand zu verringern.

Diese Aufgabe wird durch die erfindungsgemäße Einrichtung mit den Merkmalen des Anspruchs 1 gelöst, indem die an vorgegebenen Stellen mit Lötpaste bedruckte Oberseite einer Leiterplatte und die an vorgegebenen Stellen mit Kleberauftrag versehene Unterseite einer zuvor gewendeten Leiterplatte nebeneinander und taktgleich durch denselben SMD-Bestücker transportiert werden und somit einen Bestückungsnutzen bilden.

Der Druck mehrerer Leiterplatten auf einem einzigen Bestückungsnutzen, sogenannte Mehrfachleiterplatten, ist an sich allgemein bekannt. Diese Mehrfachleiterplatten bedürfen jedoch nach der Bedruckung mit Lötpaste und nach der Bestückung und Lötung der Trennung voneinander. Verfahren zur Auftrennung eines Mehrleiterplattenbestückungsnutzens in die einzelnen Leiterplatten sind z. B. aus der DE 38 06 984 A1 und der DE 38 05 487 C2 bekannt. Aus der Anmeldung P 43 42 885 vom 16.12.1993 ist es aus dem dort geschilderten Stand der Technik auch bekannt, Leirerplatten im Nutzenverbund zu liefern, wobei die Abnehmer einen nahezu 100%igen Gut-Nutzen erwarten. Zu diesem Zweck wird dort vorgeschlagen, die einzelnen Leiterplatten in einem Bestückungsnutzen bereits vor der Bestückung mit einer Trennfuge zu versehen, mit deren Hilfe die als defekt erkannten Leiterplatten aus dem Bestückungsnutzen getrennt werden können, wobei der Fugenverlauf derart gewählt ist, daß intakte Leiterplatten, die z. B. zuvor in einen anderen Nutzen übriggeblieben waren, formschlüssig in den Bestückungsnutzen einsetzbar sind.

Ein Ausführungsbeispiel zur aufeinanderfolgenden zweifachen Umkehr der Transportrichtung der Leiterplatten ist durch die Merkmale des Anspruchs 2 gekennzeichnet.

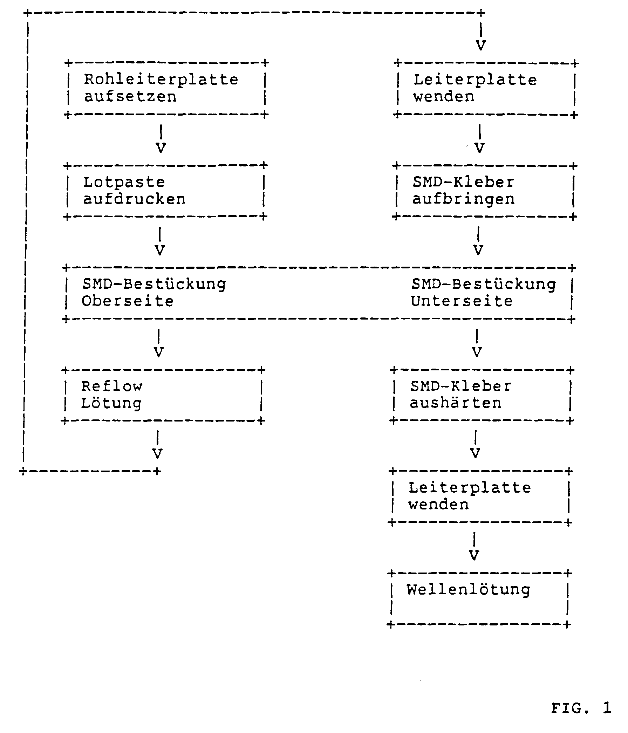

Anhand der Zeichnung wird nun dieses Ausführungsbeispiel näher erläutert. Dabei zeigt
- Fig. 1: ein allgemeines Funktionsblockdiagramm des Verfahrens,
- Fig. 2: ein stärker differenziertes Funktionsblockdiagramm des Ausführungsbeispieles,
- Fig. 3: einen Querschnitt durch einen SMD-Bestücker.

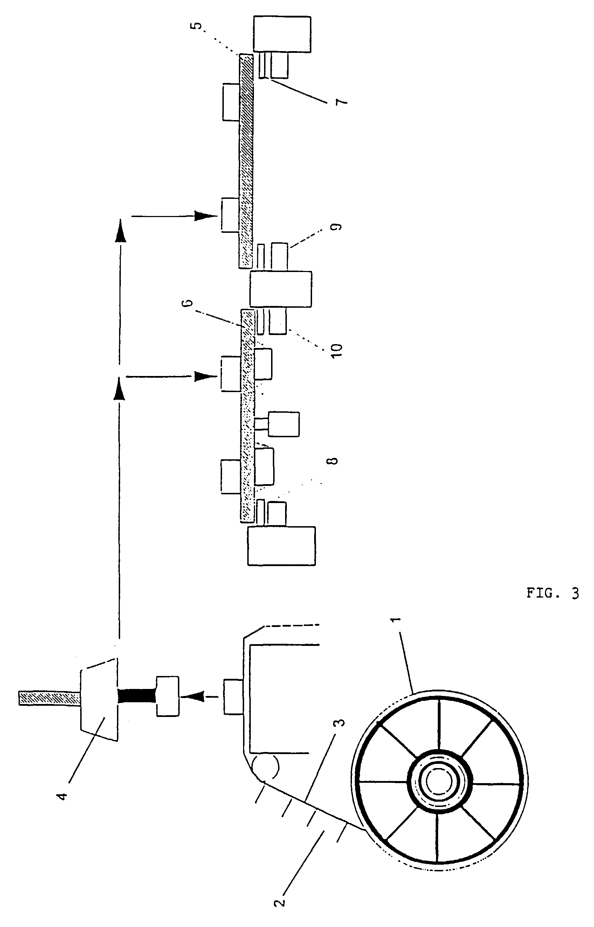

In der erfindungsgemäßen Einrichtung wird eine Rohleiterplatte aus einem Vorratsbehälter entnommen und mit nach oben weisender Oberseite auf ein Transportband aufgesetzt. Auf diese Seite der Rohleiterplatte wird danach in der Lotpastendruckstation an den Lötstellen für die zu bestückenden SMD-Bauteile, aber auch an den Kontaktbohrungen für Verbindungen von Leiterbahnen auf der Oberseite mit solchen auf der Unterseite der Leiterplatte in an sich bekannter Weise Lötpaste aufgedruckt. Anschließend durchläuft die Leiterplatte einen SMD-Bestücker auf dem Transportband, das von der ersten von zwei im SMD-Bestücker vorhandenen Aufnahmen für Transportbänder geführt wird. Ein Querschnitt durch diesen SMD-Bestücker ist in Fig. 3 näher dargestellt und wird später noch erläutert.

An den Ausgang der ersten Aufnahme in dem SMD-Bestücker schließt sich eine Reflow-Lötstation an, in der die Leiterplatten mittels Infrarotstrahlern erhitzt werden, so daß das Lot in der Lotpaste schmilzt, wobei die anderen Bestandteile der Lotpaste verdampfen. Sodann wird die Transportrichtung der Leiterplatten um 180 Grad gedreht und die Leiterplatte zum Eingang der Einfichtung zurückgebracht.

Vor dem Eingang der zweiten Aufnahme für ein Transportband im SMD-Bestücker wird die Transportrichtung der Leiterplatte erneut um 180 Grad gedreht, und die Leiterplatten durchlaufen anschließend zunächst einen Leiterplattenwender, der die Unterseite der Leiterplatte in bekannter Weise nach oben wendet, und eine Kleberstation, in welcher an den Plazierungen der SMD-Bausteine punktförmig Kleber zwischen den Bauteileanschlußlötstellen aufgetragen wird. Das Transportband läuft sodann in die zweite Aufnahme in den SMD-Bestücker ein und wird nun taktgleich neben dem Transportband in der ersten Aufnahme geführt, wobei die auf beiden Bändern transportierten Leiterplatten derart aufeinander ausgerichtet sind, daß sie für den SMD-Bestücker einen einzigen Bestückernutzen bilden.

In dem SMD-Bestücker wird der Bestücksauger an die Plazierungen für SMD-Bauteile auf beiden nebeneinanderliegenden Oberflächen von Leiterplatten gesteuert und auf beiden Oberflächen, nämlich die Oberseite einer neu eingesetzten Rohleiterplatte und die Unterseite einer bereits oberseitig bestückten und danach gewendeten Leiterplatte, werden SMD-Bauteile aufgesetzt. Die Bauteile haften auf der Oberseite der neuen Rohleiterplatte in der Lötpaste bis zur anschließenden Reflow-Lötung fest, während sie auf der Unterseite von Kleber gehalten werden.

Hinter dem Ausgang der zweiten Aufnahme in dem SMD-Bestücker ist dann eine Härtestation für den Kleber angeordnet. Danach wird die Leiterplatte erneut gewendet und schließlich die SMD-Bauteile auf der Unterseite in einem Wellenlötbad mit den Anschlußpunkten verlötet.

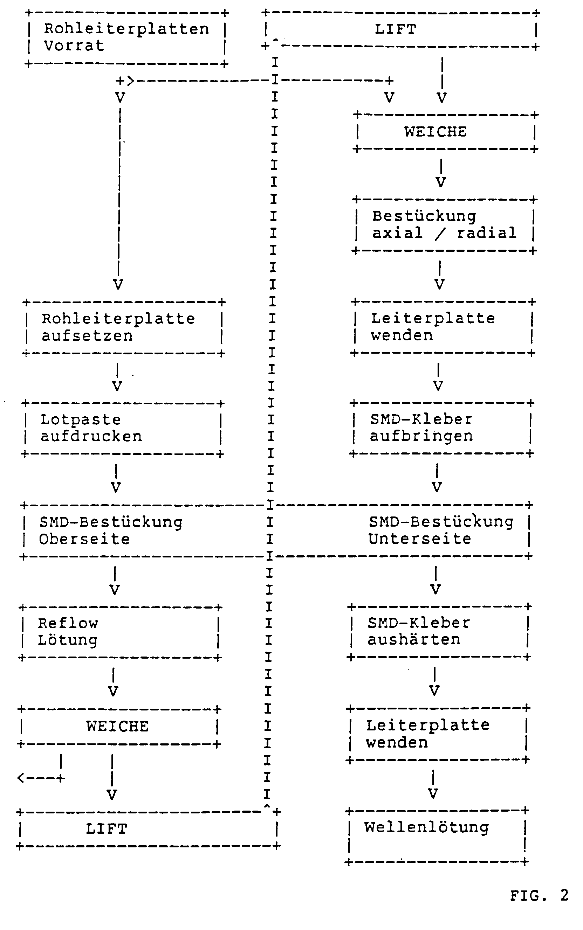

Im Bedarfsfall Können Prüfstationen und, wie in Fig. 2 angedeutet, Bestückungsplätze für Bauelemente mit radialen oder axialen Anschlüssen oder auch für Abschirmungen bzw. Gehäuseteilen vorgesehen werden, die mit den leitenden Flächen auf der Leiterplatte verlötet werden sollen.

Die Umkehrstationen für Laufrichtung der Leiterplatten können auch, falls es die Räumlichkeiten erfordern, z. B. vor der Reflow-Station, in den Verfahrensablauf integriert werden, so daß diese bereits im Rücklauf der Leiterplatte liegt.

Auch kann die Wendestation direkt hinter dem Ausgang der Reflow-Station integriert sein und erst danach die Transportrichtung erneut umgekehrt werden.

Wesentlich ist, daß die beiden ausgedehnten Oberflächen der Leiterplatte trotz Bedruckung mit unterschiedlichen Haftmitteln für die SMD-Bauteile in dem SMD-Bestücker während des Bestückungsvorgangs zu einem Bestückungsnutzen zusammengeführt sind.

Bei dem in Fig. 2 dargestellten, erweiterten Funktionsblockdiagramm ist hinter der Reflow-Lötstation eine Weiche vorgesehen, in der Leiterplatten, die nur auf der Oberseite mit SMD-Bauteilen bestückt werden sollen, ausgeschleust werden können. Die verbleibenden Leiterplatten werden dann in einem Lift von dem Transportband abgehoben und über ein rücklaufendes zweites Transporthand zu einem zweiten Lift zurückgebracht, der die Leiterplatten auf ein drittes wieder vorlaufendes Transportband aufsetzt. Auf diesen Lift folgt eine zweite Weiche, in der Rohleiterplatten, deren Oberseite nicht mit SMD-Bauteilen bestückt werden sollen, aus dem Vorratsbehälter eingeschleust werden können.

Hinter dieser zweiten Weiche ist eine Station zur Bestückung der Oberseite der Leiterplatte mit Radial- oder Axial-Bauelementen vorgesehen. Diese Bauelemente haben Anschlußdrähte, die entweder in radialer oder in axialer Richtung weisen. Nach dieser Bestückung wird die Leiterplatte, wie bereits beschrieben, gewendet, danach der Kleber aufgetragen und sodann die Leiterplatte auf dem von der zweiten Aufnahme geführten Transportband durch den SMD-Bestücker transportiert. Anschließend wird der Kleber ausgehärtet, die Leiterplatte erneut gewendet und die auf der Unterseite bestückten, vom Kleber gehaltenen SMD-Bauteile verlötet.

Der in Fig. 3 schematisch dargestellte Querschnitt durch einen SMD-Bestücker zeigt auf der linken Seite eine SMD-Bauteilevorratsrolle 1, von der die SMD-Bauteile 2 mit ihrem Trägerband 3 abgewickelt werden. Der Träger wird sodann unter einem Bestücksauger 4 hindurchgeführt, der die SMD-Bauelemente in bekannter Weise vom Träger abhebt. Der Bestücksauger 4 fährt mit den SMD-Bauteil anschließend nach rechts über die Oberfläche zweier Leiterplatten 5 und 6, die nebeneinander auf zugeordneten Transportbändern 7 und 8 aufliegen und für den SMD-Sauger einen einzigen Bestückungsnutzen bilden. Die Transport bänder ihrerseits werden in zwei nebeneinander angeordneten Aufnahmen 9 und 10 geführt.

Entsprechend den Befehlen in dem Steuerprogramm des Bestückungssaugers werden nun nacheinander die SMD-Bauteile 2 auf den zu diesem Zeitpunkt einen Bestückungsnutzen bildenden mit unterschiedlichen Haftmitteln bedruckten Oberflächen der Leiterplatten auf ihren zugeordneten Plazierungen abgesetzt. Dabei ist die untenliegende "Oberseite" der linken Leiterplatte bereits mit SMD-Bauteilen 2 sowie mit weiteren Bauelementen mit axialen Anschlußdrähten bestückt.

## Patentansprüche

1. Einrichtung zum automatischen Bestücken der Ober- und Unterseite von Leiterplatten mit SMD-Bauteilen,
wobei bei dem Bestücken die an vorgegebenen Stellen mit Lötpaste bedruckte Oberseite einer Leiterplatte und die an vorgegebenen Stellen mit Kleberauftrag versehene Unterseite einer zuvor gewendeten Leiterplatte zur Bildung eines Bestückungsnutzens nebeneinander und taktgleich durch denselben SMD-Bestücker transportiert werden,
umfassend:
Mittel zum Bedrucken der Leiterplattenoberfläche an vorgegebenen Positionen mit Lotpaste,
einen SMD-Bestücker mit zwei, in nebeneinanderliegenden Aufnahmen geführten Transportmitteln der Leiterplatte,
hinter der ersten Aufnahme des SMD-Bestückers angeordnete Mittel zum Reflow-Löten der bestückten Oberseite der Leiterplatte,
erste und zweite Mittel zur aufeinanderfolgenden zweifachen Umkehr der Transportrichtung der Leiterplatte,
erste Mittel zum Wenden der auf der Oberseite bestückten Leiterplatte,
vor der zweiten Aufnahme des SMD-Bestückers angeordnete Mittel zum Auftrag von Kleber an vorgebenen Positionen,
hinter der zweiten Aufnahme angeordnete Mittel zum Aushärten des Klebers,
zweite Mittel zum erneuten Wenden der beidseitig bestückten Leiterplatte und schließlich Mittel zum Verlöten der SMD-Baureile auf der Unterseite mit den dort aufgedruckten Leiterbahnen.

2. Einrichtung nach Anspruch 1,
dadurch gekennzeichnet,
daß die Mittel zur aufeinanderfolgenden zweifachen Umkehr der Transportrichtung der Leiterplatten aus einem ersten, die Leiterplatte von dem von der ersten Aufnahme geführten Transportmittel abnehmenden Lift und einem zweiten die Leiterplatte auf die von der zweiten Aufnahme geführten Transportmittel aufsetzenden Lift sowie aus einem die beiden Lifte verbindenden Transportmittel für die Leiterplatte besteht, dessen Laufrichtung entgegengesetzt zur Laufrichtung der Transportmittel in den Aufnahmen des SMD-Bestückers gerichtet ist.

## Claims

1. Apparatus for automatically mounting SMD components on the top and bottom sides of printed circuit boards,
in which case, during the component-mounting process, the top side of a printed circuit board, the said top side having soldering paste printed on it at predetermined locations, and the bottom side of a printed circuit board that has been turned beforehand, the said bottom side having been provided with an application of adhesive at predetermined locations, are transported through the same SMD component-mounting machine next to one another and cyclically synchronously for the purpose of forming a component-mounting panel,
comprising:
means for printing solder paste on the surface of the printed circuit board at predetermined positions,
an SMD component-mounting machine with two printed circuit board transporting means guided in adjacent receptacles,
means for reflow soldering of the populated top side of the printed circuit board, the said means being arranged downstream of the first receptacle of the SMD component-mounting machine,
first and second means for the successive double reversal of the transport direction of the printed circuit board,
first means for turning the printed circuit board with the top side populated,
means for applying adhesive at predetermined positions, the said means being arranged upstream of the second receptacle of the SMD component-mounting machine, means for curing the adhesive, the said means being arranged downstream of the second receptacle,
second means for once again turning the printed circuit board with both sides populated, and finally means for soldering the SMD components on the bottom side with the conductor tracks printed thereon.

2. Apparatus according to Claim 1,
characterized
in that the means for the successive double reversal of the transport direction of the printed circuit boards comprises a first lift, which removes the printed circuit board from the transporting means guided by the first receptacle, and a second lift, which places the printed circuit board onto the transporting means guided by the second receptacle, and also a transporting means for the printed circuit board that connects the two lifts, the running direction of which transporting means is in the opposite direction to the running direction of the transporting means in the receptacles of the SMD component-mounting machine.

## Revendications

1. Installation d'implantation automatique de composants montés en surface sur le côté supérieur et le côté inférieur de plaques de circuits imprimés, installation selon laquelle, lors de l'implantation, le côté supérieur d'une plaque de circuits imprimés, ayant reçu par impression dans des postes en amont, de la pâte à souder, et le côté inférieur d'une plaque de circuits imprimés préalablement retournée, dont les emplacements prédéterminés ont reçu une application de colle, sont transportés de manière juxtaposée et en synchronisme à travers les mêmes dispositifs d'implantation de composants montés en surface, pour former un ensemble à implanter,
installation comprenant :
- des moyens pour imprimer la surface supérieure de la plaque de circuits imprimés à des endroits prédéterminés avec de la pâte à souder,
- un dispositif d'implantation de composants montés en surface, comportant deux moyens de réception juxtaposés guidant des moyens de transport pour des plaques de circuits imprimés,
- derrière le premier moyen de réception du dispositif d'implantation de composants montés en surface, des moyens pour le soudage à la vague du côté supérieur de la plaque de circuits imprimés ayant reçu ses composants,
- un premier et un second moyen pour inverser deux fois, de manière successive, la direction de transport de la plaque de circuits imprimés,
- des premiers moyens pour retourner la plaque de circuits imprimés dont le côté supérieur a reçu les composants,
- en amont du second moyen de réception du dispositif d'implantation de composants, des moyens pour appliquer de la colle à des endroits prédéterminés,
- en aval du second moyen de réception, des moyens pour faire durcir la colle,
- des seconds moyens prévus pour retourner de nouveau la plaque de circuits imprimés ayant reçu des composants sur ses deux côtés et enfin des moyens pour souder les composants montés en surface sur le côté inférieur aux chemins conducteurs imprimés sur ce côté.

2. Installation selon la revendication 1,
caractérisée en ce que
- les moyens pour renverser deux fois de manière successive la direction de transport des plaques de circuits imprimés se composent d'un premier moyen de levage soulevant la plaque de circuits imprimés du moyen de transport qui la conduit à partir du premier moyen de réception et,
- un second moyen de levage qui dépose la plaque de circuits imprimés sur le moyen de transport guidé par le second moyen de réception, ainsi qu'un moyen de transport qui relie les deux moyens de levage pour la plaque de circuits imprimés, moyen de transport dont le sens de déplacement est opposé au sens de déplacement des moyens de transport des moyens de réception du dispositif d'implantation de composants montés en surface.
